# EUROPEAN PATENT APPLICATION

(11) **EP 1 089 605 A2**
(43) Date of publication of application: **04.04.2001**
(21) Application number: 00308548.7
(22) Date of filing: 28.09.2000
(51) Int. Cl.: H05K 9/00

(54) **Electromagnetic shielding**

(30) Priority: 29.09.1999 GB 9922946
(71) Applicant: C Brandauer & Co., Ltd., Birmingham B19 3PF (GB)
(72) Inventor: Petit, Adam Vivian Letiere, Birmingham, B19 3PF (GB)
(74) Representative: Barnfather, Karl Jon, Dr.

(57) **Abstract**

An electromagnetic shield comprising precipitation hardened stainless steel. A method of forming an electromagnetic shield comprising the following stages:
(a) making a piece of stainless steel substantially to the desired shape, and
(b) precipitation hardening the stainless steel by heat treatment to produce the finished electromagnetic shield.

## Description

This invention relates to the electromagnetic shielding of electrical or electronic equipment. More specifically, the invention relates to the use of strips of stainless steel in such shielding, and is particularly applicable to the shielding of physical gaps in equipment, using so-called "finger-strips".

Items of electrical or electronic equipment offered for sale need to conform to electromagnetic compatability legislation because of the electromagnetic radiation they emit. For example, within the European Community, equipment must conform to the EMC (Electro-Magnetic Compatability) Directive, 89/336/EEC. For compliance, equipment must neither cause electrical interference to other products, nor be unduly susceptible to external interference itself.

Equipment manufacturers commonly seek to ensure that the enclosures used to house their equipment are adequately shielded from electromagnetic (EM) radiation, as a cost-effective way of complying with regulations. However, through. the presence of slots, seams, access panels and door openings, most electronic enclosures are prone to the emission or ingress of EM radiation. Therefore, it is often necessary to plug such openings using additional EM shielding, typically in the form of elongate "finger strips" of shielding material. Such shielding strips are designed to be mounted over enclosure openings by various methods, may be conveniently cut to the required length, and may be sufficiently resilient to adapt to different widths of separation in the opening.

Historically, most finger strip shielding has been made from Beryllium Copper (BeCu), containing 1.8 to 2.0% Beryllium. This has effective shielding properties (attenuating typically over 100 dB at frequencies of up to 1 GHz, depending on the opening dimensions) as well as advantageous mechanical properties. The use of BeCu allows the intricate shapes required for finger strips to be formed while it is in a soft state. The strips are then heat treated, which causes the BeCu to harden to a spring hardness for the finished strip.

Unfortunately, the conventional use of BeCu in EM shielding has some disadvantages. It may pose some (as yet unproven) health risks with prolonged exposure, and must be disposed of with care. For these reasons, attempts have been made to use conventional hard stainless steel for EM shielding, in place of BeCu. However, when using such steel, it has been found that usually spring properties are compromised to achieve the desired shape, or, conversely, the shape chosen is compromised to achieve the desired spring properties. Therefore, conventional stainless steel has not proved to be an effective replacement for BeCu in EM shielding.

An object of the present invention is to provide an alternative material for use in electrical shielding, that avoids or at least mitigates some or all of the disadvantages outlined above.

According to a first aspect of the invention, there is provided an electromagnetic shield comprising precipitation hardened stainless steel. Preferably, the shielding comprises Type 17-7 precipitation hardened stainless steel. The shielding of the invention may comprise a surface coating having a higher electrical conductivity than the stainless steel itself; it may be surface plated with a layer of tin or nickel. The shield of the invention may be in the form of an elongate strip, sized to fit over narrow gaps in the equipment to be shielded. However, the shielding of the invention is potentially just as applicable to other shapes or configurations of shielding bodies.

According to a second aspect of the invention, there is a method of forming an electromagnetic shield, the method comprising the following stages:
(a) making a piece of stainless steel substantially to the desired shape, and
(b) precipitation hardening the stainless steel by heat treatment to produce the finished electromagnetic shield.

To provide a piece of EM shielding to the desired shape, the method stage (a) above may further comprise the following:
(ai) stamping, or chemically etching, a blank of stainless steel to the approximate shape required for the electromagnetic shield, and
(aii) forming the blank into substantially the shape of the electromagnetic shield.

It may be preferable that the method according to the second aspect of the invention also includes the following additional stages: (i) cropping the blank to a desired length between stages (ai) and (aii); (ii) a further cropping stage following the heat treatment stage (b); and (iii) a final plating stage, when the electromagnetic shield may be plated with tin, nickel or other suitably conductive materials. This method may be used for various shapes and configurations of EM shielding, although it is particularly applicable to the production of EM shielding in the form of elongate strips.

During the precipitation hardening heat treatment stage, the shaped steel may be heated to between 450° and 600°C, held at this temperature for at least 40 minutes and then air cooled. Preferably, the steel is held at the precipitation hardening temperature for longer, that is for about 60 or 90 minutes, before air cooling. However, it is preferable that the duration precipitation hardening stage is less than 120 minutes, and in the range of 60 to 90 minutes.

It is preferable that the stainless steel of the EM shield is heat treated to either condition TH 1050 or RH 950 as described later. In these cases, the heat treatment parameters to produce each condition are as follows: TH 1050: heat steel to 566°C ± 6°C, hold for 90 minutes at this temperature, then air cool to room temperature; RH 950: heat steel to 510°C ± 6°C, hold for 60 minutes at this temperature, then air cool to room temperature.

Preferably, the steel used to form the shield is in the fully annealed condition at the start of the process, ie. before the first process stage (a) above, and, as stated earlier, it is preferable that Type 17-7 stainless steel is used.

Electromagnetic shielding in accordance with the invention will now be described by way of example only, with reference to the following figures in which:
FIGURE 1 is a plan view of a typical section of elongate or finger strip EM shielding, which may be formed from the material of the invention; and
FIGURE 2 is a cross-sectional view along lines A-A of Figure 1, showing one method of connecting the finger strip to the equipment enclosure to be shielded.

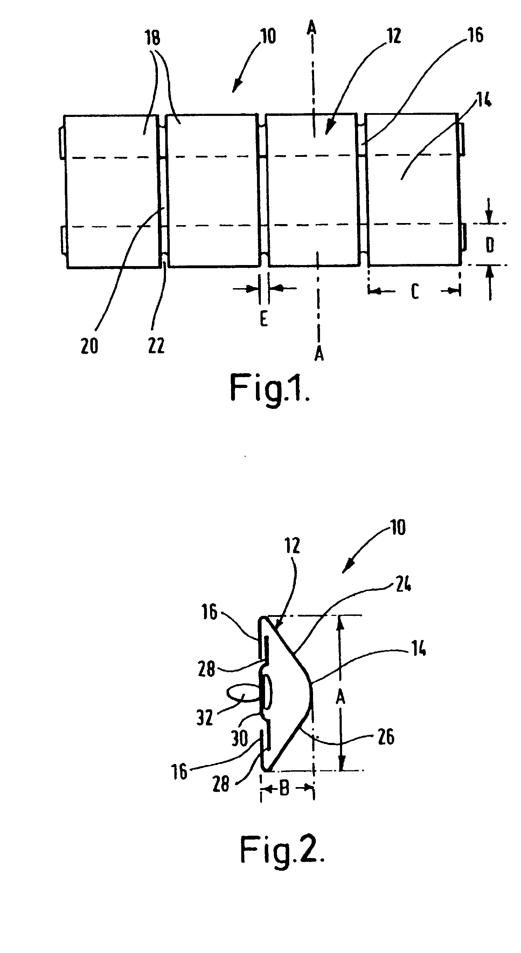

Referring to Figures 1 and 2, an elongate strip or "finger strip" of electromagnetic shielding 10 is shown, comprising a body 12 having respective upper and lower surfaces, 14 and 16. The upper surface 14 is not continuous in this case, and is divided into discrete shielding segments 18, separated by gaps 20. The gaps may also extend into the lower surface 16, as shown at lower gap 22. As can be seen from Figure 2, the shielding strip is this embodiment has a generally triangular cross-sectional profile, comprising angular walls 24 and 26, leading to two lower surface regions 16.

Elongate shielding strips 10 may be attached over the aperture to be shielded by several means. These include the use of conductive self-adhesive backing applied to the lower strip surface(s), "clip-on" fittings, track mountings and the use of direct riveting, soldering or welding. Figure 2 shows a track mounting type of fitting, wherein the lower surface regions 16 fit over, and are retained by, flanges 28 on a retention track 30. A rivet, screw or other mechanical securing means 32 may be used to fix the track to the body of a cover or enclosure to be shielded.

The material for electromagnetic shielding 10 requires good electrical conductivity, may be formed into the intricate shielding shapes required, and be flexible, allowing ease of fitting. Flexibility is further aided by segmented strip design shown, with gaps 20, 22 between strip segments 18 allowing the strip to flex out of the plane of Figure 1.

A wide range of different designs of EM shielding strip 10 can be provided. Typical strip dimensions, referring to Figure 2, are as follows: width (A): 7 - 20 mm: height (B): 3 - 8 mm; segment length (C): 4 - 9 mm, and lower surface width (D): 2 - 4 mm. Material thicknesses used to form the strips are in the range of 0.05 to 1.75 mm, according to the application, and typically in the range 0.05 - 0.08 mm. Shielding strips are available cut to length, or in reels of up to about 50 metres in some cases.

The preferred elemental composition of a preferred steel; namely Type 17-7 PH steel proposed for use in EM shielding strips is set out in Table 1 below.

**Table 1:**

| The percentage elemental compositions of the Type 17-7 stainless steel that may be precipitation hardened for use in the invention. | |
|---|---|
| Element | % Composition |
| Carbon | .09 max |
| Manganese | 1.00 max |
| Phosphorus | .04 max |
| Sulphur | .04 max |
| Silicon | 1.00 max |
| Chromium | 16.00 - 18.00 |
| Nickel | 6.50- 7.75 |
| Aluminium | .75- 1.50 |
| Molybdenum | residual |
| Iron | balance |

Any value of percentage composition up to the maximum value stated can be used but preferably the value is within 50% of the stated value and more preferably within 20% below the maximum value. Similarly, the ranges can be varied within 50% of the value stated but preferably within 20%, and each value within the specified range is hereby expressly disclosed.

Type 17-7 is a semi-austenitic grade of chromium nickel stainless steel. It may be easily formed in the austenitic annealed condition by being mill annealed, generally at a temperature of 1065°C ± 77°C. In addition, it offers good working, easy hardening, high strength and good corrosion resistance properties, as well as advantageous mechanical properties at elevated temperatures. A particular advantage in the present application to EM shielding is that stainless steel 17-7 has a ductile structure following annealing, allowing intricate strip shapes to be formed. Yet, once such shapes are formed, it may be hardened considerably by precipitation hardening heat treatment.

Further data on Type 17-7 precipitation hardened stainless steel may be found, for example, in The American Society for Testing and Materials (ASTM) data-sheet, ASTM A693. However, some basic example mechanical and physical properties of annealed Type 17-7 steel, before precipitation hardening, are set out in Table 2 below.

**Table 2:**

| Typical mechanical and physical properties of the Type 17-7 stainless steel that may be precipitation hardened for use in the invention. | |
|---|---|
| Property | Typical Value |
| Ultimate tensile strength (kg/mm² max) | 101.9 |
| 2% offset yield strength (kg/mm² max) | 31.6 |
| Elongation in 2" % (50mm) | 25 |
| Hardness Rockwell | B81 |
| Modulus of Elasticity | 20.4 |
| Magnetic Permeability at 200H | 1.4 - 3.2 |
| Electrical resistivity ohm-m x 10⁴ | 80 |
| Density (g/cm³) | 7.81 |
| Coefficient of Thermal | |
| Expansion x 10⁻⁶/°C | |
| 20 - 90°C | 15.3 |
| 20 - 200°C | 16.2 |
| 20 - 425°C | 17.3 |
| 20 - 540°C | - |
| Structure | Semi-austenitic |

A method for fabricating a EM shielding strip using a precipitation hardened stainless steel, such as Type 17-7 PH, will now be described in more detail. In general, this method permits the forming of the shield shape when the steel is in the relatively soft annealed state, followed by precipitation hardening to produce the finished product.

The method of forming EM shielding preferably comprises each of or any selection of the following process stages:
(i) Stage 1: Stamp, chemically etch or stamp and part form a blank of stainless steel into substantially the desired shape for the shielding strip. Thus a template is provided from which the shielding may be formed;
(ii) Stage 2: Crop the shielding strip blank to the desired length;
(iii) Stage 3: Form the shielding shape, ie. mechanically bend the stainless steel blank into desired strip configuration, such as the one shown in Figures 1 and 2;
(iv) Stage 4: Degrease the formed blank prior to heat treatment to remove oil, grease or other lubricants. This cleaning can be carried out by a vapour degrease, the use of solvents or by mechanical scrubbing using abrasive cleaners;
(v) Stage 5: Precipitation hardening heat treatment; this key stage will be considered in more detail below;
(vi) Stage 6: Crop the treated steel shield to the final length required and, finally,
(vii) Stage 7: Plate the hardened strip shield, for example, with tin or nickel. This gives a surface layer with good electrical conducting properties, as well as serving as a protective barrier against corrosion.

Considering the precipitation hardening step (stage 5) in more detail, the heating temperatures and time periods used will be dependent on the finished properties required. In general, the stainless steel will be heated to a temperature between 450 to 600°C, held at this temperature for at least 40 minutes, and then cooled, using air cooling, to room temperature. Longer heating periods are also possible for example 60 or 90 minutes. However, heating periods will generally be less than 120 minutes in duration, and between 60 to 90 minutes. Electric furnaces or gas fired radiant tube furnaces are preferably used for the precipitation hardening of Type 17-7 PH stainless steel.

In the invention, it is particularly envisaged that when Type 17-7 stainless steel is used it is precipitation hardened to either of the conditions designated as TH 1050 or RH 950. The parameters of the method used to produce these specific conditions are as follows:
(i) Condition TH 1050 - Heat steel to 566°C ± 6°C, hold at this temperature for 90 minutes, then air cool to room temperature and;
(ii) Condition RH 950 - Heat steel to 510°C ± 6°C, hold at this temperature for 60 minutes, then air cool to room temperature.

Prior to these heating stages, it may be necessary to cool the steels. For example, before performing the RH type heat treatment described, it is preferable to cool Type 17-7 steel to a temperature of about -73°C, and hold it at this temperature for about 8 hours.

Various mechanical and physical parameters of Type 17-7 stainless steel following heat treatments (i) and (ii) above are summarised in Table 3 below.

**Table 3:**

| Approximate suitable mechanical and physical properties of the stainless steel following precipitation hardening processes to produce conditions TH 1050 and RH 950. | | | |
|---|---|---|---|
| | Typical Values | | |
| Property | TH 1050 | RH 950 (sheet or strip) | RH 950 (plate) |
| Ultimate tensile strength (kg/mm² max) | ~157 | ~184 | ~169 |
| 2% offset yield strength (kg/mm² max) | ~146 | ~174 | ~154 |
| Elongation in 2" % (50 mm) | 9.0 | 6.0 | 9.0 |
| Hardness Rockwell | C43 | C48 | C47 |
| Magnetic permeability at 200H | 46-55 | 44-52 | 44-52 |
| Electrical resistivity ohm - m x 10⁴ | 82 | 83 | 83 |
| Density (g/cm³) | 7.65 | 7.65 | 7.65 |
| Coefficient of thermal expansion x 10⁻⁶/°C | | | |
| 20 - 90°C | 10.1 | 10.3 | 10.3 |
| 20 - 200°C | 11.0 | 11.9 | 11.9 |
| 20 - 425°C | 11.9 | 12.4 | 12.4 |

As can be seen from Table 3, the density and electrical resistivity of both conditions of steel are substantially unaffected by the precipitation hardening process. However, the magnetic permeability typically increases by a factor of about 16 to 30 times.

Any specified value given above can vary by up to 20%, but more preferably values within 10% of those specified are to be used. Any range specified specifically include hereby disclose any sub-range or value within the specified range.

## Claims

1. An electromagnetic shield comprising precipitation hardened stainless steel.

2. An electromagnetic shield according to Claim 1 wherein the precipitation hardened stainless steel is of Type 17-7.

3. An electromagnetic shield according to Claim 1 or 2 comprising a surface coating having a higher electrical conductivity than the stainless steel.

4. An electromagnetic shield according to Claims 1, 2 or 3 having a surface plating layer comprising tin.

5. An electromagnetic shield according to Claims 1, 2 or 3 having a surface plating layer comprising nickel.

6. An electromagnetic shield according to any of Claims 1 to 5 wherein the shield is in the form of an elongate strip.

7. A method of forming an electromagnetic shield comprising the following stages:
(a) making a piece of stainless steel substantially to the desired shape, and
(b) precipitation hardening the stainless steel by heat treatment to produce the finished electromagnetic shield.

8. A method of forming an electromagnetic shield according to Claim 7 wherein method stage (a) comprises the following stages:
(ai) stamping a blank of stainless steel to the approximate shape required for the electromagnetic shield, and
(aii) forming the blank into substantially the shape of the electromagnetic shield.

9. A method of forming an electromagnetic shield according to Claim 8 wherein method stage (ai) comprises chemically etching a blank of stainless steel into the approximate shape required for the electromagnetic shield.

10. A method according to Claims 8 or 9 including an additional stage of cropping the blank to a desired length between method stages (ai) and (aii).

11. A method according to Claims 7, 8, 9 or 10 including an additional stage of cropping the blank to a desired length following the precipitation hardening stage (b).

12. A method according to any of Claims 7 to 11 including a final stage wherein the electromagnetic shield is plated.

13. A method according to Claim 12 wherein the electromagnetic shield is plated with tin.

14. A method according to Claim 12 wherein the electromagnetic shield is plated with nickel.

15. A method according to any of Claims 7 to 14 wherein the electromagnetic shield is formed in the shape of an elongate strip.

16. A method according to any of Claims 7 to 15 wherein the precipitation hardening stage comprises heating the shaped steel between approximately 450 to 600°C, holding it at this temperature for at least 40 minutes, and then air cooling the steel.

17. A method according to Claim 16 wherein the precipitation hardening stage comprises heating the shaped steel to between approximately 450 to 600°C, holding it at this temperature for at least 60 minutes, and then air cooling the steel.

18. A method according to Claim 16 wherein the precipitation hardening stage comprises heating the shaped steel to between approximately 450 to 600°C, holding it at this temperature for at least 90 minutes, and then air cooling the steel.

19. A method according to Claim 16 wherein the precipitation hardening stage comprises heating the shaped steel to between approximately 450 to 600°C, holding it at this temperature for less than 120 minutes, and then air cooling the steel.

20. A method according to Claim 16 wherein the precipitation hardening stage comprises heating the shaped steel to between approximately 450 to 600°C, holding it at this temperature for approximately between 60 to 90 minutes and then air cooling the steel.

21. A method according to Claim 16 wherein the precipitation hardening stage comprises heating the shape to 566°C ± 6°C, holding it at this temperature for 90 minutes and then air cooling the steel.

22. A method according to Claim 16 wherein the precipitation hardening stage comprises heating the shape to 510°C ± 6°C, holding it at this temperature for 60 minutes, and then air cooling the steel.

23. A method according to any of Claims 7 to 22 wherein the stainless steel is annealed prior to method stage (a).

24. A method according to any of Claims 7 to 23 wherein the stainless steel is of Type 17-7.
